(19) **Europäisches Patentamt**

**European Patent Office**

**Office européen des brevets**

(11) Veröffentlichungsnummer: **0 302 167 B1**

(12) **EUROPÄISCHE PATENTSCHRIFT**

(45) Veröffentlichungstag der Patentschrift: **06.05.92**

(51) Int. Cl.⁵: **C23C 14/50**, C23C 14/34

(21) Anmeldenummer: **88103670.1**

(22) Anmeldetag: **09.03.88**

(54) **Vorrichtung zum Herstellen von Schichten mit gleichmässigem Dickenprofil auf Substraten durch Kathodenzerstäubung.**

(30) Priorität: **01.08.87 DE 3725571**

(43) Veröffentlichungstag der Anmeldung:
**08.02.89 Patentblatt  89/06**

(45) Bekanntmachung des Hinweises auf die
Patenterteilung:
**06.05.92 Patentblatt  92/19**

(84) Benannte Vertragsstaaten:
**CH DE FR GB IT LI NL**

(56) Entgegenhaltungen:
DE-A- 3 306 870
US-A- 3 785 853
US-A- 4 808 291

(73) Patentinhaber: **LEYBOLD AKTIENGESELL-
SCHAFT**
**Wilhelm-Rohn-Strasse 25, Postfach 1555**
**W-6450 Hanau am Main 1(DE)**

(72) Erfinder: **Kemmerer, Günter**
**Bogenstrasse 29**
**W-8755 Alzenau(DE)**
Erfinder: **Wolf, Hans**
**Mühlstrasse 15**
**W-6455 Erlensee(DE)**

## Beschreibung

Die Erfindung betrifft eine Vorrichtung zum Herstellen von Schichten mit gleichmäßigem Dikkenprofil auf Substraten durch Kathodenzerstäubung, bestehend aus einer Beschichtungskammer, einer in dieser ortsfest gehaltenen Zerstäubungskathode und einem durch die Beschichtungskammer quer zur Bestäubungskathode bewegbaren, in Schienen und/oder zwischen Gleit- oder Wälzkörpern gehalten und geführten Substratschlitten, wobei auf dem Substratschlitten auf seiner der Kathode zugewandten Seite eine oder mehrere Substratscheiben drehbar gelagert sind, deren Rotationsachsen jeweils senkrecht zur Bewegungsebene des Substratschlittens angeordnet sind.

Es ist eine Vorrichtung bekannt (DE-OS 33 06 870), bestehend aus einer Zerstäubungskathode und Substrathaltern auf einem gemeinsamen Fahrgestell, welches unter Ausführung einer kontinuierlichen Drehbewegung der Substrathalter gegenüber der Zerstäubungskathode verfahrbar ist. Am Fahrgestell ist dazu eine Mitnehmerrolle angeordnet, deren Drehachse senkrecht zur Fahrtrichtung verläuft, wobei parallel zur Fahrtrichtung ein Antriebsorgan angeordnet ist, mit dem die Mitnehmerrolle auf einem Teil ihres Weges in Eigriff steht und wobei die Mitnehmerrolle mit einem Substrathalter gekuppelt ist. Das Antriebsorgan ist als Endloskette ausgebildet, die über zwei in Fahrtrichtung hintereinanderliegende Kettenräder geführt ist, die über einen Antriebsmotor in Umlauf versetzbar ist, wobei jede Mitnehmerrolle über ein Kegelrad-Getriebe mit einem Substrathalter zusammenwirkt.

Diese bekannte Vorrichtung hat unter anderem den Nachteil, außerordentlich aufwendig und voluminös und gleichzeitig wenig betriebssicher zu sein.

Der vorliegenden Erfindung liegt die Aufgabe zugrunde, eine Vorrichtung des eingangs genannten Typs zu schaffen, die ohne mechanische Getriebe arbeitet, eine besonders flache Bauweise ermöglicht und ohne Wartung auskommt, so daß in keinem Falle ein Öffnen der Beschichtungskammer erforderlich ist.

Erfindungsgemäß wird dies dadurch erreicht, daß auf der der Kathode abgewandten Seite des Substratschlittens in der Beschichtungskammer mit Magneten bestückte, motorisch angetriebene Wellen, mittels der die Substratscheiben in die für die Erreichung des gleichmäßigen Dickenprofils notwendige Drehbewegung versetzt werden können, gelagert sind, deren Längsachsen sich in einer zur Bewegungsebene des Substratschlittens parallelen Ebene erstrecken.

Mit Vorteil ist dazu der Substratschlitten als eine im wesentlichen rechteckige Platte ausgebildet, auf deren Oberseite mehrere Substratscheiben drehbar gelagert sind, wobei die zugehörigen Drehachsen jeweils durch Lagerbohrungen im Substratschlitten nach unten zu hindurchgeführt sind und mit Läuferscheiben drehfest verbunden sind, die mit den mit Magneten versehen Wellen zusammenwirken.

Vorzugsweise ist sowohl jede Substratscheibe als auch jede zugehörige Läuferscheibe mit einer Nabe versehen, die beide drehfest über eine Drehachse verbunden sind, wobei jeweils ein Nabenpaar mit einem Wälzlager zusammenwirkt, dessen Lagerkäfig am Substratschlitten gehalten ist.

Um einen im Drehsinn der Substratscheiben besonders wirksamen Scheibenstrom zu erzeugen, sind die sich quer zur Bewegungsrichtung des Substratschlittens erstreckenden Wellen so bemessen, daß die mit diesen fest verbundenen Magnete sich etwa vom Bereich des äußeren Randes einer Läuferscheibe bis etwa zum Scheibenzentrum erstreckt.

Zweckmäßigerweise weist die Welle zur Halterung eines Magneten eine schachtartige Aussparung im Bereich der Läuferscheibe auf, in die ein oder mehrere Permanentmagnete eingesetzt sind, wobei die Permanentmagnete so bemessen sind, daß sie die schachtartige Aussparung ausfüllen und im übrigen der Rotationskontur der Welle angepaßt sind.

Die Erfindung läßt die verschiedensten Ausführungsmöglichkeiten zu; eine davon ist in den anhängenden Zeichnungen schematisch näher dargestellt, und zwar zeigen:

Fig. 1    eine Beschichtungskammer mit einer an oberen Wandung befestigten Zerstäubungskathode und einem unterhalb der Kathode auf Rollen gelagerten Substratschlitten und mehreren zwischen Substratschlitten und der unteren Wand der Beschichtungskammer drehbar gelagerten Wellen mit an diesen angeordneten Permanentmagneten,

Fig. 2    einen Teilschnitt des Abschnitts Z des Substratschlittens gemäß Fig. 1 in vergrößerter Darstellung und

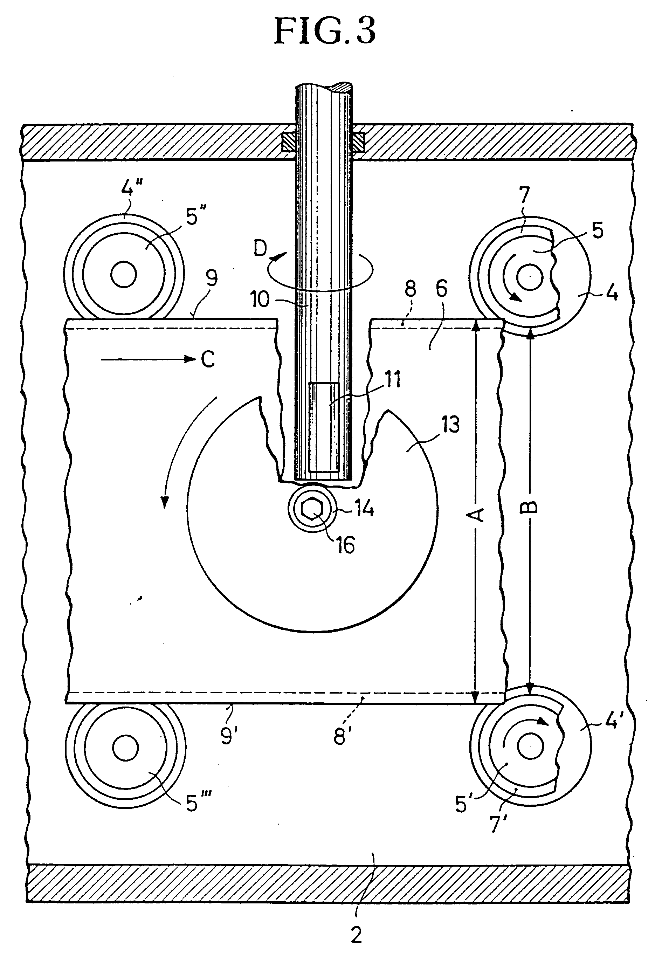

Fig. 3    die Draufsicht auf einen Abschnitt des Substratschlittens in vergrößerter Darstellung

Die Vorrichtung zum Herstellen von Schichten mit gleichmäßigem Dickenprofil besteht im wesentlichen aus einem eine Beschichtungskammer 2 haltenden Maschinengestell 1, wobei die Beschichtungskammer 2 ein etwa rechteckiges Querschnittsprofil aufweist und in derem Inneren die Zerstäubungskathode 3 und zwei zueinander parallele Reihen von Lagerböcken 4, 4', 4", ... mit auf ihnen drehbar gelagerten Führungsrollen 5, 5', 5", ... angeordnet sind, auf die der Substratschlitten 6 geführt ist. Die beiderseits offene Beschichtungskammer 2 korrespondiert mit zwei Schleusen, die in der Zeichnung nicht näher dargestellt sind und die einerseits das Ein- und Ausfahren des Substratschlittens 6 (in Pfeilrichtung) in bzw. aus der Beschichtungskammer 2 ermöglichen und andererseits das Innere der Beschichtungskammer 2 druckdicht abschließen. Der Substratschlitten 6 liegt mit in seinen beiden zueinander parallelen Längskanten 9, 9' eingearbeiteten V-förmigen Längsnuten 8, 8' an den Rollen 5, 5' an, deren obere umlaufende Ränder 7, 7' verrundet sind, wobei der Abstand A der beiden Längskanten 9, 9' des Substratschlittens 2 geringfügig größer bemessen ist als der Abstand B, den die umlaufenden Ränder 7, 7' zweier einander gegenüberliegender Führungsrollen 5, 5' voneinander haben. Die Bewegung des Substratschlittens 6 in Pfeilrichtung C wird dadurch bewirkt, daß die Rollen 5, 5', 5", ... über in den Lagerböcken 4, 4', 4", ... angeordnete Elektromotore angetrieben sind, wobei die Drehrichtung der Rollen 5, 5', ... der einen Rollenreihe entgegengesetzt der Drehrichtung der Rollen 5', 5"' ... der anderen Rollenreihe ist.

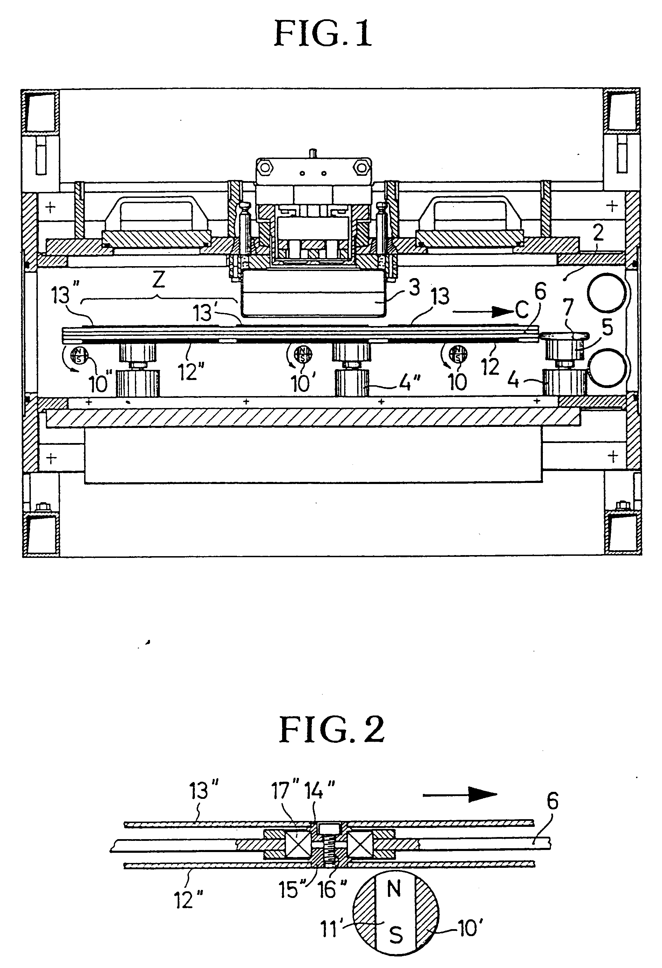

Wie Fig. 1 zeigt, sind unterhalb des Substratschlittens 6 in bestimmten Abständen Wellen 10, 10', 10" ... angeordnet, deren Rotationsachsen quer zur Bewegungsrichtung des Substratschlittens (Pfeilrichtung C) verlaufen. Diese Wellen 10, 10', ... sind elektromotorisch angetrieben und laufen während des Beschichtungsvorgangs in Pfeilrichtung D u. Da die Wellen 10, 10', ... an ihren freien, bis unter den Substratschlitten 6 reichenden Enden mit Magneten 11 versehen sind, wird in den auf dem Substratschlitten 6 gelagerten Läuferscheiben 12 ein Scheibenstrom erzeugt, der die Läuferscheiben 12 und die über Naben 14, 15 mit diesen drehfest verbundenen Substratscheiben 13 in Drehung versetzt. Die Wellen sind im dargestellten Ausführungsbeispiel durch die Wand der Beschichtungskammer 2 abgedichtet hindurchgeführt und werden von Elektromotoren angetrieben, die an der Außenseite der Beschichtungskammer (nicht dargestellt) fest angeordnet sind.

Während des Beschichtungsvorganges transportieren die sich synchron drehenden Rollen 5, 5', ... den Substratschlitten 6 langsam in Pfeilrichtung C, wobei die rasch rotierenden Wellen 10, 10', ... mit Hilfe der an diesen angeordneten Permanentmagneten 11 die Läuferscheiben 12, 12', ... und auch die mit diesen drehfest gelagerten Substratscheiben 13, 13', ... in Rotation versetzen.

Die vorstehend beschiebene Vorrichtung hat den Vorteil, daß praktisch jede Partie eines auf der Substratscheibe abgelegten oder befestigten Werkstücks, beispielsweise eines Wafers, nicht nur mit gleichmäßiger Geschwindigkeit in Pfeilrichtung C durch die Beschichtungskammer 2 hindurch und an der Zerstäubungskathode 3 vorbeibewegt wird, sondern sich auch gleichzeitig quer zur Durchlaufrichtung C bewegt, wodurch auch eine besonders gleichmäßige bzw. rotationssymmetrische Schichtdicke herstellbar ist. Die Vorrichtung arbeitet außerordentlich zuverlässig und praktisch verschleißfrei. Eine Schmierung oder besondere Wartung irgendwelcher Teile des Antriebs entfällt. Weiterhin arbeitet die Vorrichtung nahezu geräuschfrei, da beispielsweise Geräusche erzeugende Zahnradgetriebe oder Zahnriemenantriebe nicht vorhanden sind. Der Beschichtungsvorgang läßt sich schließlich durch in die Wand der Beschichtungskammer 2 eingebaute Sichtfenster genau verfolgen, da die Wellen 10, 10', ... unterhalb des Substratschlittens 6 angebracht sind, womit eine freie Sicht auf die Substrate möglich ist.

Auflistung der Einzelteile

| 1 | Maschinengestell |
|---|---|
| 2 | Beschichtungskammer |
| 3 | Zerstäubungskathode |
| 4 | Lagerbock |
| 5 | Rolle, Führungsrolle |
| 6 | Substratschlitten |
| 7 | umlaufender Rand der Rolle |
| 8 | Längsnut (V-förmig) |
| 9 | Längskante |
| 10 | Welle |
| 11 | Magnet |
| 12 | Läuferscheibe |
| 13 | Substratscheibe |
| 14 | Nabe |
| 15 | Nabe |
| 16 | Drehachse |
| 17 | Wälzlager |

**Patentansprüche**

1. Vorrichtung zum Herstellen von Schichten mit gleichmäßigem Dickenprofil auf Substraten (13, 13', ...) durch Kathodenzerstäubung, bestehend aus einer Beschichtungskammer (2), einer in dieser ortsfest gehaltenen Zerstäubungskathode (3) und einem durch die Beschichtungskammer (2) quer zur Bestäubungskathode (3) bewegbaren, in Schienen und/oder zwischen Gleit- oder Wälzkörper (5) gehalten und geführten Substratschlitten (6), wobei auf dem Substratschlitten (6) auf seiner der Kathode (3) zugewandten Seite eine oder mehrere Substratscheiben (13, 13', ...) drehbar gelagert sind, deren Rotationsachsen jeweils senkrecht zur Bewegungsebene des Substratschlittens (6) angeordnet sind, **dadurch gekennzeichnet,** daß auf der der Kathode (3) abgewandten Seite des Substratschlittens (6) in der Beschichtungskammer (2) mit Magneten (11, 11', ...) bestückte, motorisch angetriebene Wellen (10, 10', ...), mittels der die Substratscheiben (13, 13', ...) in die für die Erreichung des gleichmäßigen Dickenprofils notwendige Drehbewegung versetzt werden können, gelagert sind, deren Längsachsen sich in einer zur Bewegungsebene des Substratschlittens (6) parallelen Ebene erstrecken.

2. Vorrichtung nach Anspruch 1, **dadurch gekennzeichnet,** daß der Substratschlitten (6) als eine im wesentlichen rechteckige Platte ausgebildet ist, auf deren Oberseite mehrere Substratscheiben (13, 13', ...) drehbar gelagert sind, wobei die zugehörigen Drehachsen (16, 16', ...) jeweils durch Lagerbohrungen im Substratschlitten (6) nach unten zu hindurchgeführt sind und mit Läuferscheiben (12, 12', ...) drehfest verbunden sind, die mit den Magneten (11, 11', ...) versehenen Wellen (10, 10', ...) zusammenwirken.

3. Vorrichtung nach den Ansprüchen 1 und 2, **dadurch gekennzeichnet,** daß sowohl jede Substratscheibe (13, 13', ...) als auch jede zugehörige Läuferscheibe eine Nabe (14, 14', ... bzw. 15, 15', ...) aufweist, die beide drehfest über eine Drehachse (16, 16', ...) verbunden sind, wobei jeweils ein Nabenpaar mit einem Wälzläger (17, 17', ...) zusammenwirkt, dessen Lagerkäfig am Substratschlitten (6) gehalten ist.

4. Vorrichtung nach einem oder mehreren der Ansprüche 1 bis 3, **dadurch gekennzeichnet,** daß die sich quer zur Bewegungsrichtung (C) des Substratschlittens (6) erstreckenden Wellen (10, 10', ...) so bemessen sind, daß die mit diesen fest verbundenen Magneten (11, 11', ...) sich etwa vom Beeich des äußeren Randes einer Läuferscheibe (12, 12', ...) bis etwa zum Zentrum dieser Läuferscheibe erstreckt.

5. Vorrichtung nach einem oder mehreren der vorhergehenden Ansprüche, **dadurch gekennzeichnet,** daß jede Welle (10, 10', ...) zur Halterung eines Magneten eine schachtartige Aussparung im Bereich der Läuferscheibe (12, 12', ...) aufweist, in die ein oder mehrere Permanentmagnete (11, 11', ...) eingesetzt sind, wobei die Permanentmagnete so bemessen sind, daß sie die schachtartige Aussparung ausfüllen und im übrigen der Rotationskontur der Welle angepaßt sind.

**Claims**

1. A device for the formation of coatings with a uniform thickness profile on substrates (13, 13', ....) by cathode sputtering, comprising a coating chamber (2), a sputtering cathode (3) fixed therein, and a substrate glide (6) which is moveable through the coating chamber (2) transversely to the sputtering cathode (3) and which is held and guided in rails and/or between sliding or rolling bodies (5), wherein one or more substrate plates (13, 13', ...) are rotatably mounted on the substrate slide (6) on its side facing towards the cathode (3), the axes of rotation of said substrate plates each extending at right angles to the plane of movement of the substrate slide (6), characterised in that on the side of the substrate slide (6) facing away from the cathode (3) in the coating chamber (2) are mounted motor driven shafts (10, 10', ...) which are equipped with magnets (11, 11', ...) and by means of which the substrate plates (13, 13', ...) can be set in the rotary movement necessary for the attainment of the uniform thickness profile, the longitudinal axes of said shafts extending in a plane parallel to the plane of movement of the substrate slide (6).

2. A device as claimed in Claim 1, characterised in that the substrate slide (6) has the form of a substantially rectangular plate, on the upper side of which a plurality of substrate plates (13, 13', ...) are rotatably mounted, where the associated pivot pins (16, 16', ...) extend downwards through respective bearing bores in the substrate slide (6) and are connected, so as to be rotation-resistant, to rotor plates (12, 12', ...) which cooperate with the shafts (10, 10', ...) equipped with magnets (11, 11', ...).

3. A device as claimed in Claims 1 and 2, characterised in that each substrate plate (13, 13', ...) and each associated rotor plate comprises a respective hub (14, 14', .... and 15, 15',. ...), both of which are connected so as to be rotation-resistant via a pivot pin (16, 16'...), where a respective pair of hubs cooperates with a roller bearing (17, 17', ...), the bearing cage of which is mounted on the substrate slide (6).

4. A device as claimed in one or more of Claims 1 to 3, characterised in that the shafts (10, 10', ...) which extend transversely to the direction of movement (C) of the substrate slide (6) are designed such that the magnets (11, 11', ...) permanently connected to said shafts extend approximately from the region of the outer edge of a rotor plate (12, 12', ...) approximately to the centre of said rotor plate.

5. A device as claimed in one of more of the preceding claims, characterised in that for the retention of a magnet each shaft (10, 10', ...) comprises a chute-like opening in the region of the rotor plate (12, 12', ...) into which opening are inserted one or more permanent magnets (11, 11', ...), where the permanent magnets are designed such that they fill the chute-like opening and are also adapted to the rotation contour of the shaft.

**Revendications**

1. Appareil pour produire des couches d'un profil d'épaisseur uniforme sur des substrats (13, 13',...) par pulvérisation cathodique, comprenant une chambre de revêtement (2), une cathode de pulvérisation (3) tenue en position fixe dans cette chambre et un chariot porte-substrats (6), qu'on peut faire passer à travers la chambre de revêtement (2) transversalement à la cathode de pulvérisation (3), qui est tenu et guidé dans des rails et/ou entre des organes glissants ou roulants (5), et dans lequel un ou plusieurs disques porte-substrat dont les axes de rotation sont orientés perpendiculairement au plan de déplacement du chariot porte-substrat est ou sont monté(s) rotatif(s) sur le chariot porte-substrats, sur la face de ce chariot qui est dirigée vers la cathode, caractérisé en ce que, dans la chambre de revêtement (2), sur le côté du chariot porte-substrats (6) qui est le plus éloigné de la cathode (3), sont montés rotatifs des arbres (10, 10', ...) garnis d'aimants (11, 11', ...), entraînés par un moteur, au moyen desquels les disques de substrats (13, 13', ...) peuvent être animés du mouvement de rotation nécessaire pour obtenir le profil d'épaisseur uniforme, et dont les axes longitudinaux s'étendent dans un plan parallèle au plan du déplacement du chariot porte-substrats (6).

2. Appareil selon la revendication 1, caractérisé en ce que le chariot porte-substrats (6) est avantageusement réalisé sous la forme d'un plateau sensiblement rectangulaire sur la face supérieure duquel plusieurs disques de substrats (13, 13', ...) sont montés rotatifs, les axes de rotation (16, 16', ...) de ces disques étant enfilés de haut en bas à travers des perçages de portée pratiqués dans le chariot porte-substrats (6) et étant reliés solidairement en rotation à des disques rotors (12, 12', ...) qui coopèrent avec les arbres (10, 10', ...) munis d'aimants (11, 11', ...).

3. Appareil selon les revendications 1 et 2, caractérisé en ce que chaque disque de substrat (13, 13', ...) et chaque disque rotor correspondant sont avantageusement munis de moyeux (14, 14', ... ou 15, 15', ...) qui sont assemblés solidairement en rotation par un axe de rotation (16, 16', ...), chaque paire de moyeux coopérant avec un roulement (17, 17', ...) dont la cage est fixée au chariot porte-substrats (6).

4. Appareil selon une ou plusieurs des revendications 1, à 3, caractérisé en ce que les arbres (10, 10', ...) qui s'étendent transversalement à la direction (C) du défilement du chariot porte-substrats (6) sont dimensionnés de manière que les aimants (11, 11', ...) qui leur sont fixés rigidement s'étendent à peu près de la région du bord extérieur d'un disque rotor (12, 12', ...) à peu près jusqu'au centre du disque.

5. Appareil selon une ou plusieurs des revendications précédentes, caractérisé en ce que chaque arbre (10, 10', ...) présente, pour tenir un aimant, un évidement en forme de puits situé dans la région du disque rotor (12, 12', ...) et dans lequel un ou plusieurs aimants permanents (11, 11', ...) est ou sont encastré(s), les aimants permanents étant calculés de manière à remplir l'évidement en forme de puits et étant adaptés par ailleurs au profil de rotation de l'arbre.

# FIG.1

# FIG.2

FIG.3